# FASCICULE DE BREVET EUROPEEN

(11) **EP 3 676 076 B1**
(45) Date de publication et mention de la délivrance du brevet: **28.10.2026**
(21) Numéro de dépôt: 18769762.8
(22) Date de dépôt: 28.08.2018
(51) Int. Cl.: B29C 63/00, H10F 71/00, B32B 43/00, B32B 38/10

(54) **PROCEDE DE DESASSEMBLAGE D'UN MODULE PHOTOVOLTAÏQUE ET INSTALLATION ASSOCIEE**
VERFAHREN ZUR DEMONTAGE EINES PHOTOVOLTAIKMODULS UND ZUGEHÖRIGE ANLAGE
METHOD FOR DISASSEMBLING A PHOTOVOLTAIC MODULE AND ASSOCIATED INSTALLATION

(30) Priorité: 30.08.2017 FR 1758013
(43) Date de publication de la demande: 08.07.2020
(73) Titulaire: Commissariat à l'Energie Atomique et aux Energies Alternatives, 75015 Paris (FR)
(72) Inventeur: COUSTIER, Fabrice, 73000 Chambery (FR); MESSAOUDI, Paul, 73230 Saint-Alban Leysse (FR); SERASSET, Marion, 73170 Saint Paul Sur Yenne (FR); VELET, Nicolas, 38510 Vezeronce-Curtin (FR)
(74) Mandataire: INNOV-GROUP
(86) Numéro de dépôt international: PCT/FR2018/052115
(87) Numéro de publication internationale: WO 2019/043331

(56) Documents cités:
- EP-A1- 1 830 411
- WO-A1-2015/051977

## Description

### Domaine de l'invention

Le domaine de l'invention concerne le désassemblage d'un module photovoltaïque, notamment lorsque le module photovoltaïque arrive en fin de vie, ou lorsque le module photovoltaïque est un rebut de production.

### Etat de la technique

Les modules photovoltaïques sont utilisés pour générer de l'électricité à partir du rayonnement solaire. Un module photovoltaïque comporte de nombreux éléments intéressants à récupérer, notamment dans le cadre d'un recyclage en fin de vie du module photovoltaïque ou en cas de défaillance du module photovoltaïque. Un module photovoltaïque peut comporter une enveloppe d'encapsulation de cellules photovoltaïques assurant aussi un maintien mécanique d'un élément de protection avant du module photovoltaïque, comme une plaque ou un panneau de verre, avec un élément de protection arrière du module photovoltaïque comme une feuille de protection, aussi appelée feuille de protection arrière. La feuille de protection peut comporter un polymère fluoré comme un poly(fluorure de vinyle) - aussi nommé polyfluorure de vinyle - dont le sigle est PVF. Le PVF peut être du Tedlar^{®} tel que commercialisé par la société DuPont^{™}

Une technique simple utilisée en vue de recycler un module photovoltaïque est de le broyer, puis de réaliser des traitements thermiques, ou chimiques, afin de séparer certains matériaux entrant dans sa composition, comme par exemple le verre, ou des métaux nobles comme l'argent ou le cuivre. Un inconvénient de cette technique est qu'elle est peu respectueuse de l'environnement. Par ailleurs, un autre inconvénient de cette technique est qu'elle est coûteuse en énergie. Encore un autre inconvénient de cette technique est que la montée en température du matériau de la feuille de protection décrite peut provoquer des émanations importantes de polluants toxiques à partir du polymère fluoré. Encore un autre inconvénient de cette technique est qu'elle ne permet pas de récupérer intacts, ou majoritairement intacts, un ou plusieurs constituants du module photovoltaïque.

La demande de brevet FR3017551 propose de retirer par enroulement une feuille arrière d'un module photovoltaïque, ladite feuille arrière comportant du polyfluorure de vinyle. Le retrait est assisté par chauffage du module photovoltaïque. Le retrait proposé présente l'inconvénient de nécessiter un apport de chaleur conséquent au niveau du module photovoltaïque, ceci ayant un coût et pouvant entrainer un dégagement important de gaz toxiques à partir du polyfluorure de vinyle.

La demande de brevet CN103085116 propose d'utiliser un fil chauffant passant dans un matériau encapsulant des cellules photovoltaïques, ce matériau encapsulant étant de l'Ethylène Acétate de Vinyle. L'utilisation d'un fil chauffant présente les inconvénients suivants :
- l'apport de chaleur nécessaire engendre une consommation d'énergie thermique présentant un certain coût,
- le fil chauffant a de forts risques de rompre du fait de sa température, et des contraintes qu'il subit lors de son passage dans le matériau encapsulant,
- une telle utilisation n'est pas adaptée à un module photovoltaïque comportant une feuille de protection comprenant un polymère fluoré car la montée en température peut provoquer une émanation importante de gaz toxiques.

Le document « Production of Recyclable crystalline Si PV Modules » de M.A.A. Goris et al. publié en 2015 lors de la « 31st European Photovoltaic Solar Energy Conference and Exhibition », session 5 EO.1.2 p1925-1929, propose d'utiliser un fil de découpe combiné à un chauffage du module photovoltaïque pour séparer des cellules photovoltaïques par rapport à un panneau de verre du module photovoltaïque. Bien que le fil combiné à la montée en température du module photovoltaïque permette de faciliter la séparation de différents éléments du module photovoltaïque, une telle montée en température présente l'inconvénient d'engendrer une consommation d'énergie non négligeable. Un autre inconvénient de la solution décrite dans ce document est qu'elle n'est pas adaptée à un module photovoltaïque à feuille de protection arrière comportant un polymère fluoré car il y aurait un risque de dégagement important de gaz toxiques lors de son retrait du fait du chauffage du module photovoltaïque. Autres documents concernant le désassemblage d'un module photovoltaïque sont WO 2015/051977 A1, EP1830411 A1, DE19539699A1, JP2015110201A et JP2002169014A.

### Objet de l'invention

L'invention est telle que définie dans les revendications 1 et 12. Les modes de réalisation préférés sont exposés dans l'ensemble des revendications dépendantes ci-jointes. L'invention vise à remédier au moins en partie aux inconvénients précités. En particulier, l'invention propose une solution permettant de retirer un élément de protection dit « arrière » du module photovoltaïque, et adoptant notamment la forme d'une feuille de protection arrière du module photovoltaïque.

A cet effet, l'invention a pour objet un procédé de désassemblage d'un module photovoltaïque comportant :
- un premier élément de protection formant une face avant du module photovoltaïque destinée à être orientée pour recevoir le rayonnement solaire,
- un deuxième élément de protection formant une face arrière du module photovoltaïque,
- des cellules photovoltaïques agencées entre le premier élément de protection et le deuxième élément de protection,
- une enveloppe d'encapsulation des cellules photovoltaïques, ladite enveloppe reliant le premier élément de protection au deuxième élément de protection,
ledit procédé de désassemblage comportant une étape de retrait du deuxième élément de protection comprenant:
- une étape d'enlèvement d'une partie de l'enveloppe en utilisant un faisceau de particules énergétiques issu d'une tête de découpe pour désolidariser le deuxième élément de protection par rapport aux cellules photovoltaïques,
- une étape d'écartement progressif du deuxième élément de protection par rapport aux cellules photovoltaïques au fur et à mesure de l'avancement de l'étape d'enlèvement de la partie de l'enveloppe, et jusqu'à retrait définitif du deuxième élément de protection, caractérisé en ce que le procédé comporte également :
   - une étape de guidage de la tête de découpe pour orienter le faisceau de particules énergétiques au cours de l'étape d'enlèvement de la partie de l'enveloppe, l'étape de guidage comportant : - une étape de détermination d'une zone du module photovoltaïque dans laquelle le faisceau de particules énergétiques doit être orienté,- une étape d'utilisation d'un détecteur de matériaux pour déterminer ladite zone, - une étape de calcul de la trajectoire de la tête de découpe par un module de traitement à partir de données fournies par le détecteur de matériaux.

Un avantage associé à un tel procédé de désassemblage, et en particulier à l'étape de retrait du deuxième élément de protection, est qu'il n'est pas nécessaire de faire monter le module photovoltaïque en température pour permettre de séparer le deuxième élément de protection du reste du module photovoltaïque. La combinaison de l'étape d'enlèvement et de l'étape d'écartement permet de faciliter le retrait en utilisant la tête de découpe.

Le procédé de désassemblage peut comporter une ou plusieurs des caractéristiques suivantes :
- au cours de l'étape d'enlèvement de la partie de l'enveloppe, le faisceau de particules énergétiques se déplace de sorte à mettre en œuvre un enlèvement progressif de matière de la partie de l'enveloppe ;
- le faisceau de particules énergétiques est un faisceau laser, ou un jet d'eau abrasif, ou un faisceau laser assisté par un jet d'eau ;
- le faisceau de particules énergétiques se déplace selon une longueur et une largeur du module photovoltaïque de sorte que le faisceau de particules énergétiques provoque un enlèvement de matière de la partie de l'enveloppe sur toute la longueur et sur toute la largeur du module photovoltaïque ;
- l'étape d'écartement progressif du deuxième élément de protection par rapport aux cellules photovoltaïques est mise en œuvre par enroulement du deuxième élément de protection autour d'un organe d'enroulement, ou par traction du deuxième de protection dans une direction tendant à l'écarter des cellules photovoltaïques ;
- l'étape d'écartement progressif du deuxième élément de protection comporte une étape de saisie d'un bord du deuxième élément de protection situé à un bord du module photovoltaïque, et une étape d'éloignement du bord du deuxième élément de protection par rapport audit bord du module photovoltaïque ;
- à tout moment après le début et avant le terme de l'étape d'enlèvement de la partie de l'enveloppe, le deuxième élément de protection comporte :
   - une première partie libérée, et
   - une deuxième partie reliée au reste du module photovoltaïque par une portion restante de la partie de l'enveloppe,
   et la première partie libérée est maintenue à l'écart du reste du module photovoltaïque par l'étape d'écartement de sorte que le faisceau de particules énergétiques puisse accéder à ladite portion restante ;
- le procédé de désassemblage comporte une étape de guidage de la tête de découpe pour orienter le faisceau de particules énergétiques au cours de l'étape d'enlèvement de la partie de l'enveloppe ;
- la tête de découpe suit, au cours de l'étape d'enlèvement de la partie de l'enveloppe, une trajectoire établie par l'étape de guidage de la tête de découpe ;
- l'étape de guidage comporte une étape d'acquisition d'images du module photovoltaïque, et une étape d'utilisation des images acquises pour établir la trajectoire ;
- l'étape de guidage comporte :
   - une étape de détermination d'une zone du module photovoltaïque dans laquelle le faisceau de particules énergétiques doit être orienté,
   - une étape d'utilisation d'un détecteur de matériaux pour déterminer ladite zone ;
- le procédé de désassemblage comporte, après l'étape de retrait, une étape de séparation des cellules photovoltaïques par rapport au premier élément de protection par découpe d'une portion de l'enveloppe, en utilisant un fil abrasif ;
- le procédé de désassemblage comporte une étape de maintien à plat du premier élément de protection, l'étape de retrait étant mise en œuvre au cours de l'étape de maintien à plat du premier élément de protection.

L'invention est aussi relative à une installation pour le désassemblage d'un module photovoltaïque, ledit module photovoltaïque comportant un premier élément de protection formant une face avant du module photovoltaïque destinée à être orientée pour recevoir le rayonnement solaire, un deuxième élément de protection formant une face arrière du module photovoltaïque, des cellules photovoltaïques agencées entre le premier élément de protection et le deuxième élément de protection, une enveloppe d'encapsulation des cellules photovoltaïques, ladite enveloppe reliant le premier élément de protection au deuxième élément de protection. L'installation comporte un poste de retrait du deuxième élément de protection muni d'un outil pour écarter le deuxième élément de protection par rapport aux cellules photovoltaïques. Le poste de retrait comporte une tête de découpe configurée de sorte à générer un faisceau de particules énergétiques pour mettre en œuvre un enlèvement d'une partie de l'enveloppe lorsque le module photovoltaïque est dans le poste de retrait en vue de désolidariser le deuxième élément de protection par rapport aux cellules photovoltaïques. L'outil pour écarter le deuxième élément de protection est configuré de sorte à écarter progressivement le deuxième élément de protection par rapport aux cellules photovoltaïques au fur et à mesure de l'avancement de l'enlèvement de la partie de l'enveloppe, et jusqu'à retrait définitif du deuxième élément de protection,- l'installation comportant :- des moyens de guidage de la tête de découpe pour orienter le faisceau de particules énergétiques au cours de l'étape d'enlèvement de la partie de l'enveloppe,- Les moyens de guidage comportant :- des moyens de détermination d'une zone du module photovoltaïque dans laquelle le faisceau de particules énergétiques doit être orienté,- un détecteur de matériaux pour déterminer ladite zone,- un module de traitement configuré pour déterminer la trajectoire de la tête de découpe à partir de données fournies par le détecteur de matériaux.

### Description sommaire des dessins

D'autres avantages et caractéristiques ressortiront clairement de la description qui va suivre de modes particuliers de réalisation de l'invention donnés à titre d'exemples non limitatifs et représentés sur les dessins annexés, dans lesquels :
- La figure 1 illustre un module photovoltaïque vu en perspective selon un mode de réalisation particulier ;
- La figure 2 illustre une vue selon une coupe transversale du module photovoltaïque de la figure 1 ;
- La figure 3 illustre une vue en perspective du module photovoltaïque représenté en figure 1 pour lequel des coupes partielles de certains éléments le formant ont été représentées pour visualiser des cellules photovoltaïques du module photovoltaïque ;
- La figure 4 illustre schématiquement des étapes d'un procédé de désassemblage selon un mode de réalisation particulier ;
- Les figures 5 à 7 illustrent un premier mode de réalisation d'une étape de retrait d'un deuxième élément de protection ;
- Les figures 8 à 10 illustrent un deuxième mode de réalisation de l'étape de retrait du deuxième élément de protection ;
- La figure 11 illustre une vue en perspective du module photovoltaïque dans un poste de découpe permettant de séparer les cellules photovoltaïques par rapport à un premier élément de protection dit « avant » du module photovoltaïque ;
- La figure 12 illustre une vue selon une coupe transversale de la figure 11 ;
- La figure 13 illustre un exemple d'une portion de fil abrasif ;
- La figure 14 illustre un perfectionnement pour lequel les cellules photovoltaïques sont écartées au fur et à mesure d'une découpe mise en œuvre par le fil abrasif.

Dans ces figures, les mêmes références sont utilisées pour désigner les mêmes éléments.

Par ailleurs, les éléments représentés sur les figures ne sont pas nécessairement à l'échelle pour faciliter la compréhension des figures.

### Description de modes particuliers de réalisation

Dans la présente description, par « à base de » on entend « comporte au moins majoritairement ».

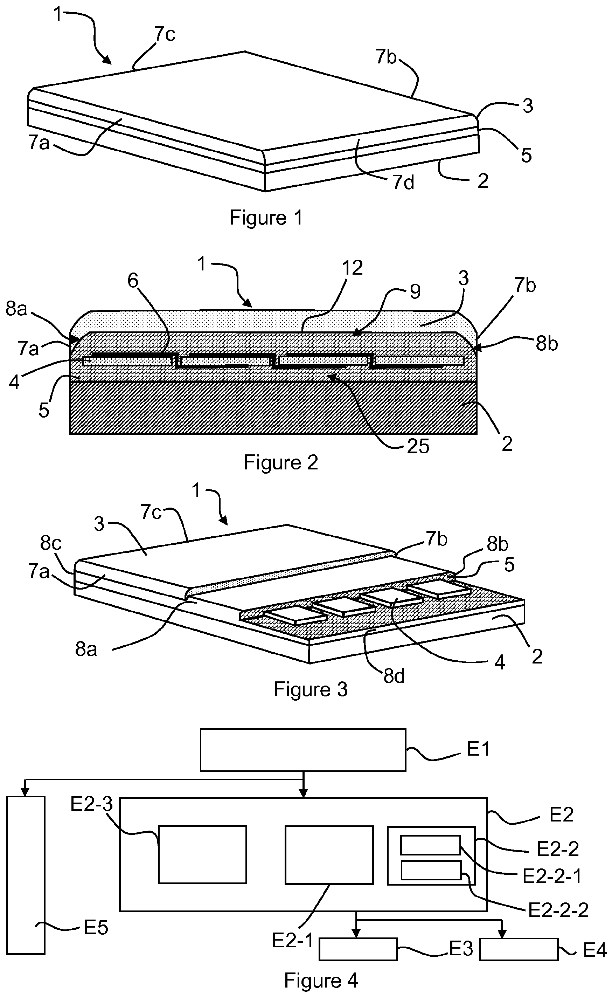

Les figures 1 à 3 illustrent un module photovoltaïque 1 pouvant être utilisé dans le cadre du procédé de désassemblage et de l'installation de désassemblage décrits plus en détails ci-après. De manière générale, le module photovoltaïque 1 peut comporter un premier élément de protection 2 formant une face avant du module photovoltaïque 1. Ce premier élément de protection 2 est apte à laisser passer un rayonnement solaire. De préférence, le premier élément de protection 2 est en verre ou à base de verre. Le premier élément de protection 2 peut être une couche, ou une plaque, ou un panneau, notamment de verre ou à base de verre. Le module photovoltaïque 1 comporte aussi un deuxième élément de protection 3 formant une face arrière du module photovoltaïque 1. La face arrière du module photovoltaïque 1 est opposée à la face avant du module photovoltaïque 1. Les faces avant et arrière sont notamment des faces externes du module photovoltaïque 1. Ce deuxième élément de protection 3 est également appelé feuille de protection 3 arrière (ou « backsheet » en langue anglaise). La face avant du module photovoltaïque 1 est notamment destinée à être orientée pour recevoir le rayonnement solaire en vue de permettre la conversion d'énergie solaire en électricité par des cellules photovoltaïques 4 du module photovoltaïque 1. Ces premier et deuxième éléments de protection 2, 3 permettent notamment de protéger les cellules photovoltaïques 4. Entre les premier et deuxième éléments de protection 2, 3, les cellules photovoltaïques 4, interconnectées entres elles, sont encapsulées dans un ou plusieurs matériaux d'encapsulation formant une enveloppe 5 dite d'encapsulation appartenant au module photovoltaïque 1. Par la suite, l'enveloppe 5 représente l'enveloppe d'encapsulation des cellules photovoltaïques 4. A titre d'exemple, sur les figures 2 et 3, quatre cellules photovoltaïques 4 sont visibles. Les cellules photovoltaïques 4 du module photovoltaïque 1 sont, de préférence, agencées selon un même plan de sorte à former un squelette de cellules photovoltaïques 4 également connu sous le nom anglo-saxon de « string », en particulier reliées électriquement en série par des connecteurs 6 (visibles en figure 2 et non représentés sur la figure 3). Les cellules photovoltaïques 4 sont agencées, c'est-à-dire situées, entre le premier élément de protection 2 et le deuxième élément de protection 3. L'enveloppe 5 relie le premier élément de protection 2 au deuxième élément de protection 3. L'enveloppe 5 permet, d'une part, de protéger les cellules photovoltaïques 4 de l'environnement extérieur en les encapsulant, et, d'autre part, d'assurer l'assemblage du premier élément de protection 2 au deuxième élément de protection 3, et donc d'assurer l'assemblage des cellules photovoltaïques 4 aux premier et deuxième éléments de protection 2, 3. Autrement dit, les cellules photovoltaïques 4 sont solidaires du premier élément de protection 2 et du deuxième élément de protection 3 par l'intermédiaire de l'enveloppe 5. Lors de la fabrication du module photovoltaïque 1, il est possible de réaliser un empilement comportant successivement le premier élément de protection 2, au moins une feuille en un matériau destiné à encapsuler les cellules photovoltaïques 4 dit matériau d'encapsulation, les cellules photovoltaïques 4, de préférence au moins une autre feuille en un matériau destiné à encapsuler les cellules photovoltaïques 4 dit matériau d'encapsulation, puis le deuxième élément de protection 3. Ensuite, l'empilement est laminé à chaud de sorte que le ou les matériaux d'encapsulation fusionnent et forment l'enveloppe 5 d'où il résulte l'obtention de la structure évoquée ci-dessus du module photovoltaïque 1.

Le deuxième élément de protection 3 peut comporter un polymère fluoré, notamment un poly(fluorure de vinyle) (dont le sigle est PVF) par exemple tel que commercialisé par la société DuPont^{™} sous le nom de Tedlar^{®}. Notamment, le deuxième élément de protection 3 peut comporter un empilement des couches suivantes : une couche en PVF, une couche en poly(téréphtalate d'éthylène) (dont le sigle est PET), une couche en PVF. La couche en PET est agencée entre les couches en PVF. Notamment, le deuxième élément de protection 3 est souple de sorte à permettre son écartement tel que décrit par la suite. Le deuxième élément de protection 3 peut être composé d'un matériau souple en polymère fluoré.

Le deuxième élément de protection 3, notamment comportant le polymère fluoré, présente l'avantage d'assurer une protection contre les variations de température, les atmosphères corrosives, l'humidité, et le sel. Le deuxième élément de protection 3 peut aussi assurer une fonction d'imperméabilité aux gaz et à l'eau, une fonction de protection électrique (isolation électrique), et une fonction de protection mécanique. Notamment, les couches en PVF permettent de former une barrière à l'humidité et la couche en PET permet de former une protection électrique (isolation électrique). Le premier élément de protection 2 peut assurer, en plus de la transmission du rayonnement solaire, une fonction de rigidification et de protection contre les agressions extérieures, comme par exemple la grêle, une fonction d'imperméabilité aux gaz et à l'eau, une fonction de protection contre les ultraviolets et une fonction de protection électrique (isolation électrique).

Le deuxième élément de protection 3 peut comporter des rebords 7a, 7b, 7c, 7d en contact avec l'enveloppe 5, notamment avec des bords dits latéraux 8a, 8b, 8c, 8d (figures 2 et 3) de l'enveloppe 5. Ces rebords 7a, 7b, 7c, 7d ainsi que les bords latéraux 8a, 8b, 8c, 8d de l'enveloppe 5 peuvent être au moins en partie arrondis du fait du laminage évoqué ci-dessus pour former le module photovoltaïque 1. En particulier, le deuxième élément de protection 3 comporte quatre rebords 7a, 7b, 7c, 7d chacun en contact avec un bord latéral correspondant de l'enveloppe 5. La présence de ces rebords 7a, 7b, 7c, 7d est notamment la conséquence du laminage à chaud évoqué précédemment. Les bords latéraux de l'enveloppe 5 sont des bords qui relient deux faces opposées de l'enveloppe 5, ces deux faces opposées de l'enveloppe 5 sont notamment respectivement en contact avec le premier élément de protection 2 et le deuxième élément de protection 3.

De manière générale, le ou les matériaux d'encapsulation formant l'enveloppe 5 peuvent être de l'éthylène acétate de vinyle (ou EVA sigle de « Ethylene-Vinyl Acetate » en langue anglaise), ou plus particulièrement être à base d'éthylène acétate de vinyle. L'EVA présente des propriétés satisfaisantes pour encapsuler les cellules photovoltaïques 4.

L'enveloppe 5 peut présenter, entre les cellules photovoltaïques 4 et le deuxième élément de protection 3, une épaisseur comprise entre 100µm et 400µm, et notamment strictement à inférieure à 300µm ou à 200µm. Par ailleurs, entre les cellules photovoltaïques 4 et le premier élément de protection 2, l'enveloppe 5 peut présenter une épaisseur comprise entre 100µm et 400µm, et notamment strictement à inférieure à 300µm ou à 200µm.

Le module photovoltaïque peut aussi comporter un cadre (non représenté), par exemple en aluminium, venant enserrer des faces opposées respectivement formées par une face du deuxième élément de protection et une face du premier élément de protection. Dans le cadre du procédé de désassemblage décrit ci-après, le module photovoltaïque ne comporte pas ce cadre de protection qui pourra avoir été retiré au préalable si ce dernier était présent. Le module photovoltaïque peut aussi être associé à une boîte de jonction qui est aussi retirée avant de désassembler le module photovoltaïque selon le procédé de désassemblage décrit ci-après.

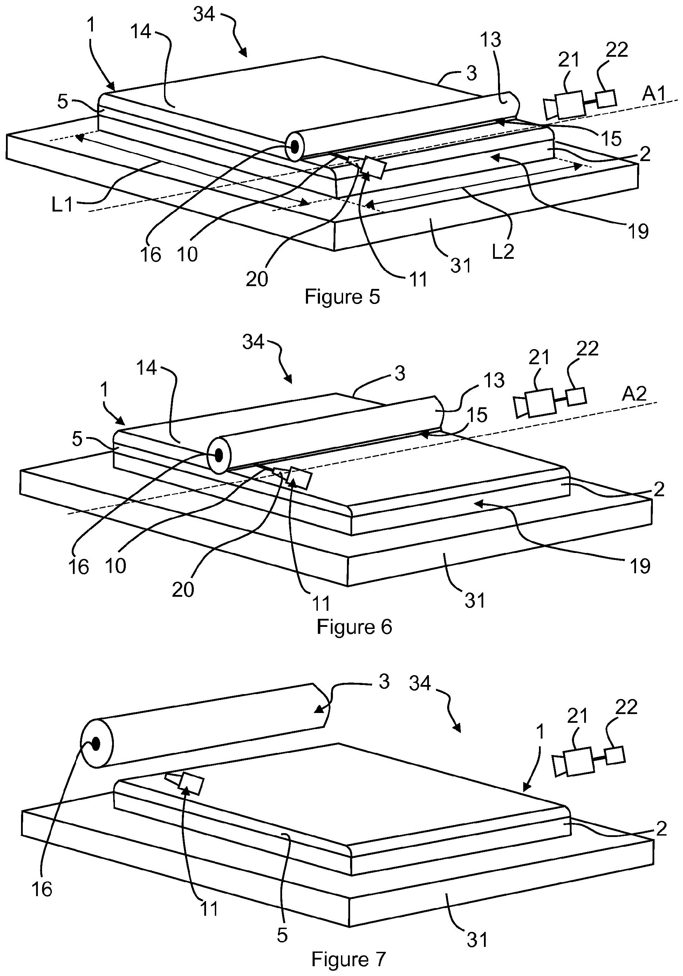

Il est à présent décrit un procédé de désassemblage d'un module photovoltaïque 1, notamment tel que décrit précédemment et pouvant être du type de celui illustré aux figures 1 à 3. Un tel module photovoltaïque 1 comporte le premier élément de protection 2 formant la face avant du module photovoltaïque 1, le deuxième élément de protection 3 formant la face arrière du module photovoltaïque 1, les cellules photovoltaïques 4 agencées entre le premier élément de protection 2 et le deuxième élément de protection 3, et l'enveloppe 5 d'encapsulation des cellules photovoltaïques 4, ladite enveloppe 5 reliant le premier élément de protection 2 au deuxième élément de protection 3. Ainsi, le procédé de désassemblage peut comporter (figure 4) une étape E1 de fourniture du module photovoltaïque 1 tel que décrit précédemment. De manière générale, le procédé de désassemblage comporte une étape de retrait E2 du deuxième élément de protection 3 tel que cela est illustré à titre d'exemple en figures 5 à 10. L'étape de retrait E2 permet de retirer, depuis le module photovoltaïque 1, le deuxième élément de protection 3. L'étape de retrait E2 du deuxième élément de protection 3 comporte une étape d'enlèvement E2-1 d'une partie 9 (visible en figure 2) de l'enveloppe 5 en utilisant, c'est-à-dire par, un faisceau 10 de particules énergétiques issu d'une tête de découpe 11 pour désolidariser le deuxième élément de protection 3 par rapport aux cellules photovoltaïques 4. On dit alors que la partie 9 de l'enveloppe 5 comporte une matière à enlever. Par ailleurs, l'étape de retrait E2 comporte une étape d'écartement E2-2 progressif du deuxième élément de protection 3 par rapport aux cellules photovoltaïques 4 (ou plus généralement par rapport au reste du module photovoltaïque) au fur et à mesure de l'avancement de l'étape d'enlèvement E2-1 de la partie 9 de l'enveloppe 5.

Le faisceau 10 de particules énergétiques va permettre de retirer localement la partie 9 de l'enveloppe 5 sans nécessiter une étape supplémentaire de chauffe qui aurait par exemple pour conséquence de favoriser des dégagements toxiques depuis le deuxième élément de protection 3 si ledit deuxième élément de protection 3 comporte un ou des polymères fluorés. Par ailleurs, l'étape de retrait E2 décrite évite les risques de recollement du deuxième élément de protection 3 au reste du module photovoltaïque 1 du fait de la mise en œuvre de l'étape d'écartement E2-2. Le procédé de désassemblage permet préférentiellement de retirer le deuxième élément de protection 3 tout en le gardant intact en vue de le recycler via une filière adaptée.

Le faisceau 10 de particules énergétiques peut être limité en profondeur de retrait de matière, car la distance selon laquelle il peut pénétrer dans la matière qu'il doit enlever ne dépasse pas quelques centimètres. C'est en ce sens que l'étape d'écartement E2-2 progressif du deuxième élément de protection 3 permet, au fur et à mesure de l'enlèvement de la partie 9 de l'enveloppe 5 au cours de l'étape d'enlèvement E2-1, d'assurer l'accès du faisceau 10 de particules énergétiques à de la matière de l'enveloppe 5 pour permettre la mise en œuvre de l'étape d'enlèvement E2-1.

Notamment, la partie 9 de l'enveloppe 5 à retirer comporte une surface de contact 12 (figure 2) avec le deuxième élément de protection 3, ladite surface de contact 12 assurant l'assemblage de l'enveloppe 5 au deuxième élément de protection 3. L'enlèvement de la partie 9 de l'enveloppe 5 se fait alors préférentiellement au plus proche du deuxième élément de protection 3. Selon une autre formulation, le faisceau 10 de particules énergétiques est orienté de sorte à enlever la partie 9 de l'enveloppe 5 à la surface de contact 12, c'est-à-dire à l'interface entre l'enveloppe 5 et le deuxième élément de protection 3. L'interface est ici la limite commune entre le deuxième élément de protection 3 et l'enveloppe 5 où sont assemblés le deuxième élément de protection 3 et l'enveloppe 5. De préférence, le faisceau 10 de particules énergétiques est focalisé dans l'enveloppe 5, notamment à l'interface entre l'enveloppe 5 et le deuxième de protection 3, pour permettre l'enlèvement de matière de la partie 9 de l'enveloppe 5 : ceci présente l'avantage de limiter la présence de résidus de l'enveloppe 5 sur le deuxième élément de protection 3 retiré, par exemple en vue de faciliter la mise en œuvre de l'étape d'écartement E2-2 du fait d'une souplesse accrue du deuxième élément de protection 3. Au terme de l'étape de retrait E2, le faisceau 10 de particules énergétiques a préférentiellement balayé toute l'interface entre l'enveloppe 5 et le deuxième élément de protection 3. Au terme de l'étape de retrait E2, le module photovoltaïque 1 comporte le premier élément de protection 2 et l'enveloppe 5 (contenant les cellules photovoltaïques 4) notamment telle que modifiée par l'étape de retrait E2 : le deuxième élément de protection 3 est alors séparé du module photovoltaïque 1. On comprend aussi que de manière générale, l'utilisation d'un faisceau 10 permet de suivre plus facilement l'interface entre l'enveloppe 5 et le deuxième élément de protection 3, notamment lorsque cette interface n'est pas plane et qu'elle peut présenter au moins à certains endroits une forme arrondie due au laminage à chaud évoqué précédemment.

De préférence, au cours de l'étape d'enlèvement E2-1 de la partie 9 de l'enveloppe 5, le faisceau 10 de particules énergétiques se déplace de sorte à mettre en œuvre un enlèvement progressif de matière de la partie 9 de l'enveloppe 5. Le déplacement du faisceau 10 peut être mis en œuvre par déplacement de la tête de découpe 11. Ceci permet d'éviter un échauffement global du module photovoltaïque 1 : tout éventuel échauffement dû à l'enlèvement de matière de la partie 9 de l'enveloppe 5 se fera localement pour éviter/limiter les dégagements gazeux issus du deuxième élément de protection 3.

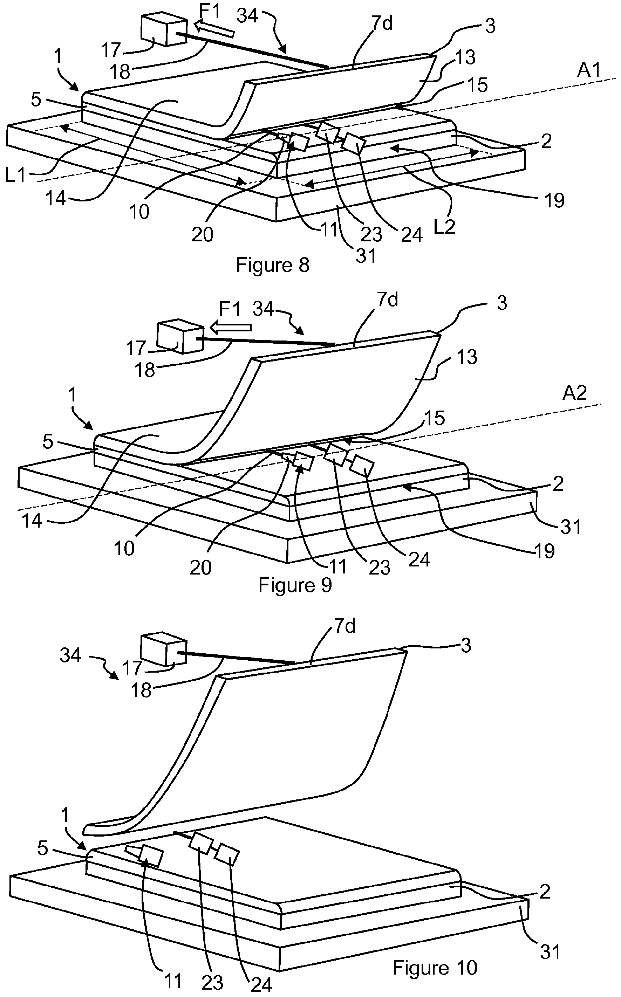

Les figures 5 à 7 et 8 à 10 illustrent deux modes de réalisation de l'étape de retrait E2 qui permettent de comprendre ce que l'on entend de manière préférée par « écartement progressif du deuxième élément de protection 3 par rapport aux cellules photovoltaïques 4 ». Aux figures 5 à 10, les cellules photovoltaïques 4 ne sont pas visibles car encapsulées au sein de l'enveloppe 5. De manière plus générale, et notamment commune à ces deux modes de réalisation de l'étape de retrait E2, à tout moment après le début et avant le terme de l'étape d'enlèvement E2-1 de la partie 9 de l'enveloppe 5 (figures 5, 6 et figures 8, 9), le deuxième élément de protection 3 comporte une première partie 13 libérée et une deuxième partie 14 reliée au reste du module photovoltaïque 1 par une portion restante 15 de la partie 9 de l'enveloppe 5. La première partie 13 est dite libérée de l'enveloppe 5 car elle n'est plus en contact direct avec cette dernière. Dans ce cas, la première partie 13 libérée est maintenue à l'écart (c'est-à-dire éloignée) du reste du module photovoltaïque 1 (notamment de l'enveloppe 5) par l'étape d'écartement E2-2 de sorte que le faisceau 10 de particules énergétiques puisse accéder à ladite portion restante 15 de la partie 9 de l'enveloppe 5. L'avantage est donc ici de faciliter l'accès du faisceau 10 à la matière à enlever. Ainsi, au fur et à mesure de l'avancement de l'étape d'enlèvement E2-1 de la partie 9 de l'enveloppe 5, la première partie 13 libérée présente des dimensions qui augmentent, la deuxième partie 14 comporte des dimensions qui diminuent, et la portion restante 15 de la partie 9 de l'enveloppe 5 présente des dimensions qui diminuent. Au terme de l'étape d'enlèvement E2-1 de la partie 9 de l'enveloppe 5, le deuxième élément de protection 3 est séparé du reste du module photovoltaïque 1, et donc des cellules photovoltaïques 4 comme illustré en figures 7 et 10. Sur les figures 5 et 6, ainsi que sur les figures 8 et 9, il est représenté l'état du module photovoltaïque 1 entre deux moments différents situés après le début, et avant le terme, de l'étape d'enlèvement E2-1 de la partie 9 de l'enveloppe 5. Ainsi, au terme de l'étape de retrait E2, le deuxième élément de protection 3 peut être recyclé indépendamment.

L'étape d'écartement E2-2 progressif peut aussi être appelée étape de pelage. On dit aussi qu'elle est mise en œuvre par pelage du deuxième élément de protection 3 (figures 5, 6, 8, 9). Au sens de la présente description, le pelage est une action mécanique qui consiste à maintenir éloignée la première partie 13 libérée par rapport au reste du module photovoltaïque 1 pendant que le faisceau 10 de particules énergétiques enlève de la matière de la partie 9 de l'enveloppe 5, c'est-à-dire réalise une découpe de l'enveloppe 5 d'où il résulte la suppression de la partie 9 de l'enveloppe 5 évoquée ci-avant.

Comme illustré en figures 5 à 7, l'étape d'écartement E2-2 progressif peut être mise en œuvre par enroulement du deuxième élément de protection 3, notamment autour d'un organe d'enroulement 16, par exemple un cylindre accouplé à un moteur et muni d'une pince pour saisir le deuxième élément de protection 3. Alternativement, comme illustré en figures 8 à 10, l'étape d'écartement E2-2 peut être mise en œuvre par traction (selon la flèche F1 aux figures 8 et 9) du deuxième élément de protection 3 (notamment de la première partie 13 libérée) dans une direction tendant à l'écarter des cellules photovoltaïques 4. La traction peut être réalisée par un outil de traction 17 relié au deuxième élément de protection 3 (notamment à la première partie 13 libérée) par exemple par un câble 18. L'enroulement ou la traction permet, au fur et à mesure de l'avancement de l'étape d'enlèvement E2-1 de la partie 9 de l'enveloppe 5, que la première partie 13 libérée du deuxième élément de protection 3 ne vienne pas entraver le bon déroulement de l'enlèvement du reste de la partie 9 de l'enveloppe 5. L'enroulement est préféré car il améliore les conditions de travail du faisceau 10 de particules énergétiques en permettant un réglage plus libre de la trajectoire de la tête de découpe 11. Par ailleurs, l'enroulement est plus fiable : en effet, dès qu'un tour du cylindre est effectué après la saisie d'un bout du deuxième élément de protection 3 par la pince, le bout du deuxième élément de protection 3 est définitivement maintenu par l'enroulement du deuxième élément de protection 3 sur lui-même, alors que dans le cas du câble 18 une rupture est possible à la liaison entre le câble 18 et le deuxième élément de protection 3.

De manière générale, que cela soit par enroulement ou traction, une force de tension peut être appliquée au deuxième élément de protection 3 pour mettre en œuvre l'étape d'écartement E2-2. L'application de cette force de tension peut être automatisée par exemple par une jauge de contrainte, pour permettre de s'adapter à des phases, plus ou moins difficiles, d'enlèvement de matière de la partie 9 de l'enveloppe 5 par le faisceau 10.

Avantageusement, et de préférence en combinaison avec l'enroulement, ou la traction, du deuxième élément de protection 3, l'étape d'écartement E2-2 progressif du deuxième élément de protection 3 par rapport aux cellules photovoltaïques 4 comporte (figure 4) une étape de saisie E2-2-1 d'un bord (par exemple le rebord 7d évoqué ci-avant et visible en figures 8 à 10) du deuxième élément de protection 3 situé à un bord 19 (figures 5, 6, 8 et 9) du module photovoltaïque 1, et une étape d'éloignement E2-2-2 du bord du deuxième élément de protection 3 par rapport audit bord 19 du module photovoltaïque 1. Ceci découle des figures 5 à 10 où l'on comprend que le bord représenté par la référence 7d en figure 1, et visible en figures 8 à 10, a été saisi et s'éloigne petit à petit du bord 19 du module photovoltaïque 1. L'étape de saisie E2-2-1 peut avoir lieu après déclenchement de l'étape d'enlèvement E2-1 de la partie 9 de l'enveloppe 5 de sorte à autoriser la saisie d'un bord de la première partie 13 libérée. Cette saisie du bord du deuxième élément de protection 3 permet de faciliter la mise en œuvre de l'étape d'écartement E2-2. L'étape saisie E2-2-1 du bord du deuxième élément de protection 3 peut être mise en œuvre par les étapes suivantes :
- une étape de réalisation d'une amorce par découpe dans l'enveloppe 5 par le faisceau 10 sur quelques centimètres, ladite amorce formant alors la première partie 13 libérée,
- une étape de préhension de l'amorce, par exemple par un système mécanique comme une pince (pneumatique, hydraulique, ou purement mécanique) ou par un système de vide type Bernoulli,
- une étape d'activation d'un cycle de maintien en tension adapté du deuxième élément de protection 3 pour assurer un espacement, entre la première partie 13 libérée et le reste du module photovoltaïque 1, suffisant au bon fonctionnement du faisceau 10.

On comprend de ce qui a été décrit précédemment, et en relation avec les figures 5, 6, 8 et 9 que le faisceau 10 de particules énergétiques se déplace avantageusement selon une longueur L1 et une largeur L2 (L1 et L2 étant illustrées à titre d'exemple en figures 5 et 8) du module photovoltaïque 1 de sorte que le faisceau 10 de particules énergétiques provoque l'enlèvement de matière de la partie 9 de l'enveloppe 5 sur toute la longueur et sur toute la largeur du module photovoltaïque 1. Ceci présente l'avantage, qu'au terme de l'étape d'enlèvement E2-1 de la partie 9 de l'enveloppe 5, une fraction de l'enveloppe 5 selon son épaisseur est retirée d'où il résulte la séparation du deuxième élément de protection 3 du reste du module photovoltaïque 1 et donc son retrait du module photovoltaïque 1.

Selon une réalisation particulière, la partie 9 de l'enveloppe 5 est constituée par un ensemble de segments à retirer. La tête de découpe 11 est alors configurée pour se déplacer le long d'une pluralité d'axes de découpe distincts parallèles entre eux et échelonnés selon la longueur ou la largeur du module photovoltaïque 1. Chaque axe de découpe est associé à un segment à retirer. Au cours de l'étape de retrait E2, pour chaque axe de découpe, la tête de découpe 11 se déplace le long dudit axe de découpe de sorte que le faisceau 10 retire un des segments de l'ensemble de segments, notamment au moins en partie rectiligne, s'étendant entre deux bords opposés du module photovoltaïque 1. Les figures 5, 6, 8 et 9 montrent notamment deux axes de découpe A1 et A2. La tête de découpe 11 peut se déplacer de gauche à droite sur les figures 5, 6, 8 et 9 à une vitesse imposée permettant l'enlèvement de matière souhaité.

Par « le faisceau 10 de particules énergétiques issu d'une tête de découpe 11 », on entend que la tête de découpe 11 génère ce faisceau 10 de particules énergétiques. La tête de découpe 11 permet de concentrer le faisceau 10 de particules vers une zone où de la matière de la partie 9 de l'enveloppe 5 doit être enlevée. En particulier, la tête de découpe 11 comporte une buse 20 (figures 5, 6, 8 et 9), aussi appelée canon de focalisation, permettant de focaliser les particules énergétiques, et donc le faisceau 10, au niveau d'une zone ponctuelle où de la matière doit être enlevée. Selon une réalisation, le faisceau 10 de particules énergétiques est un faisceau laser, les particules énergétiques sont des photons. Le faisceau laser peut être assisté par un jet d'eau dont le rôle est de guider le faisceau laser pour que celui-ci soit cylindrique et non conique. Selon une autre réalisation, le faisceau 10 de particules énergétiques est un jet d'eau abrasif, les particules du faisceau comportent des particules (aussi appelées molécules) d'eau et des particules abrasives (par exemple en SiC, en corindon par exemple naturel, ou formées par du sable de grenat). De préférence, les particules abrasives du jet d'eau abrasif présentent une grande dureté (Mohs supérieur à 8) et une granulométrie permettant de s'adapter au besoin de l'étape de retrait E2. Ces particules abrasives du jet d'eau abrasif sont propulsées par les particules d'eau contenues dans le jet d'eau abrasif de sorte que les particules abrasives du jet d'eau abrasif présentent une énergie cinétique suffisante pour réaliser l'enlèvement de matière à l'endroit où le jet d'eau abrasif vient en contact avec la matière de la partie 9 de l'enveloppe 5. Ces réalisations du faisceau 10 sont tout particulièrement adaptées pour l'enlèvement de matière souhaité de la partie 9 de l'enveloppe 5 car, le cas échéant, l'échauffement est limité à l'endroit où la matière est enlevée. Le jet d'eau abrasif en tant que faisceau 10 présente l'avantage de ne pas apporter d'échauffement, l'avantage de limiter la consommation énergétique, et est plus simple à mettre en œuvre. Les avantages du faisceau laser sont qu'il est plus précis car il présente un trait de coupe plus fin, et qu'il n'implique pas de retraiter du liquide souillé. Lorsque le faisceau 10 est un jet d'eau abrasif, la pression du jet d'eau abrasif peut être comprise entre 1000 bars et 6000 bars. La quantité de particules abrasives du jet d'eau abrasif peut être adaptée selon les besoins. En particulier, le jet d'eau abrasif peut être tel que la profondeur de retrait de matière évoquée précédemment peut aller jusqu'à 50cm. En particulier, le faisceau laser peut être tel que la profondeur de retrait de matière évoquée précédemment peut aller jusqu'à 50mm.

De manière plus générale, pour réaliser une découpe efficace, la pression du jet d'eau abrasif peut être strictement supérieure à 600 bars.

Lors de l'utilisation du jet d'eau abrasif, celui-ci peut être orienté de sorte à former un angle de 15 degrés par rapport au plan du module photovoltaïque à désassembler.

La buse 20 évoquée ci-dessus peut présenter, lorsque le faisceau 10 de particules énergétiques est un jet d'eau abrasif, un diamètre compris entre 80µm et 800µm, et par exemple égal à 180µm. Un tel diamètre de buse est tout particulièrement adapté dans la présente application de désassemblage de module photovoltaïque.

Avantageusement, le faisceau 10 de particules énergétiques a un diamètre strictement inférieur à, ou une dimension transversale maximale strictement inférieure à, l'épaisseur de l'enveloppe 5 entre les cellules photovoltaïques 4 et le deuxième élément de protection 3 de sorte à favoriser que seule de la matière de la partie 9 de l'enveloppe 5 soit retirée au cours de l'étape de retrait E2. Ce diamètre, ou cette dimension transversale maximale, est notamment mesuré dans une zone de contact du faisceau 10 avec la partie 9 de l'enveloppe 5. Notamment, le diamètre ou la dimension transversale maximale peut être compris entre 20µm et 100µm, ou entre 50µm et 300µm, ou peut être égal à 100µm, pour les dimensions données ci-avant d'épaisseur de l'enveloppe 5 entre les cellules photovoltaïques 4 et le deuxième élément de protection 3.

De préférence (figure 4), le procédé de désassemblage, notamment l'étape de retrait E2, comporte une étape de guidage E2-3 de la tête de découpe 11 pour orienter le faisceau 10 de particules énergétiques au cours de l'étape d'enlèvement E2-1 de la partie 9 de l'enveloppe 5. Ainsi, la tête de découpe 11 peut suivre, au cours de l'étape d'enlèvement E2-1 de la partie 9 de l'enveloppe 5, une trajectoire établie par l'étape de guidage E2-3 de la tête de découpe 11. Ceci permet d'optimiser l'enlèvement de matière en sachant où orienter le faisceau 10. Cela permet aussi d'assurer, par exemple, que seule de la matière issue de l'enveloppe 5 est bien enlevée par le faisceau 10. Le guidage est aussi avantageux lorsque le deuxième élément de protection 3 comporte les rebords 7a, 7b, 7c, 7d qui peuvent empêcher de simples mouvements rectilignes de la tête de découpe 11 pour enlever un segment tel que décrit précédemment.

Notamment, l'étape de guidage E2-3 peut assurer que la matière enlevée de la partie 9 de l'enveloppe 5 le soit à l'interface entre le deuxième élément de protection 3 et l'enveloppe 5 comme décrit précédemment.

Selon une première réalisation de l'étape de guidage E2-3, l'étape de guidage E2-3 peut comporter une étape d'acquisition d'images du module photovoltaïque 1, et une étape d'utilisation des images acquises pour établir la trajectoire de la tête de découpe 11. L'utilisation d'images acquises présente l'avantage de savoir où le faisceau 10 interagit avec l'enveloppe 5, et où l'on souhaite qu'il interagisse ensuite. On comprend alors que la trajectoire est préférentiellement établie au fur et à mesure de l'enlèvement de la matière de la partie 9 de l'enveloppe 5. Les images peuvent donc être acquises au cours de l'étape d'enlèvement E2-1. Sur les figures 5 à 7, il est représenté une caméra 21 permettant l'acquisition des images. Cette caméra 21 est reliée à un module de traitement 22 des images acquises pour établir/calculer la trajectoire. Bien entendu, cette première réalisation de l'étape de guidage E2-3 peut aussi s'appliquer dans le cadre de l'écartement mis en œuvre par traction des figures 8 à 10.

Selon une deuxième réalisation de l'étape de guidage E2-3, l'étape de guidage E2-3 peut comporter une étape de détermination d'une zone du module photovoltaïque 1 dans laquelle le faisceau de particules énergétiques doit être orienté, et une étape d'utilisation d'un détecteur de matériaux pour déterminer ladite zone. On comprend ici que l'étape d'utilisation du détecteur de matériaux permet avantageusement de sonder/examiner le module photovoltaïque 1, par exemple en localisant un ou plusieurs matériaux du module photovoltaïque 1, en vue de déterminer où le faisceau 10 doit être orienté pour réaliser l'enlèvement de matière de la partie 9 de l'enveloppe 5. En détectant et en localisant un ou plusieurs matériaux via le détecteur de matériaux, il est possible de déterminer dans quelle zone doit être orienté le faisceau 10. Sur les figures 8 à 10, il est représenté un détecteur de matériaux 23 relié à un module de traitement 24 des données du détecteur 23 pour établir/calculer la trajectoire. Bien entendu, cette deuxième réalisation de l'étape de guidage E2-3 peut aussi s'appliquer dans le cadre de l'écartement mis en œuvre par enroulement des figures 5 à 7.

Le détecteur 23 de matériaux peut être un duromètre, ou encore un détecteur par spectroscopie sur plasma induit par laser (au connu sous le sigle LIBS correspondant à « Laser-induced Breakdown Spectroscopie » en langue anglaise). Par exemple, le duromètre peut permettre d'établir des différences de dureté de matériaux pour déterminer la zone correspondante. Ces deux types de détecteur 23 sont tout particulièrement adaptés pour déterminer la zone concernée où doit être focalisé le faisceau 10. Le duromètre présente l'avantage de fonctionner par contact, et permet donc de simplifier la détection de matériau(x). Le détecteur de type LIBS permet un asservissement indexé à une composition chimique, ceci sera plus coûteux à mettre en œuvre, mais beaucoup plus précis que le duromètre.

Selon une troisième réalisation de l'étape de guidage E2-3, la structure du module photovoltaïque 1 étant connue, le guidage de la tête de découpe 11 peut être réalisé à partir d'un plan de structure du module photovoltaïque 1, par exemple enregistré dans une mémoire et récupéré par un calculateur mettant en œuvre l'étape de guidage E2-3.

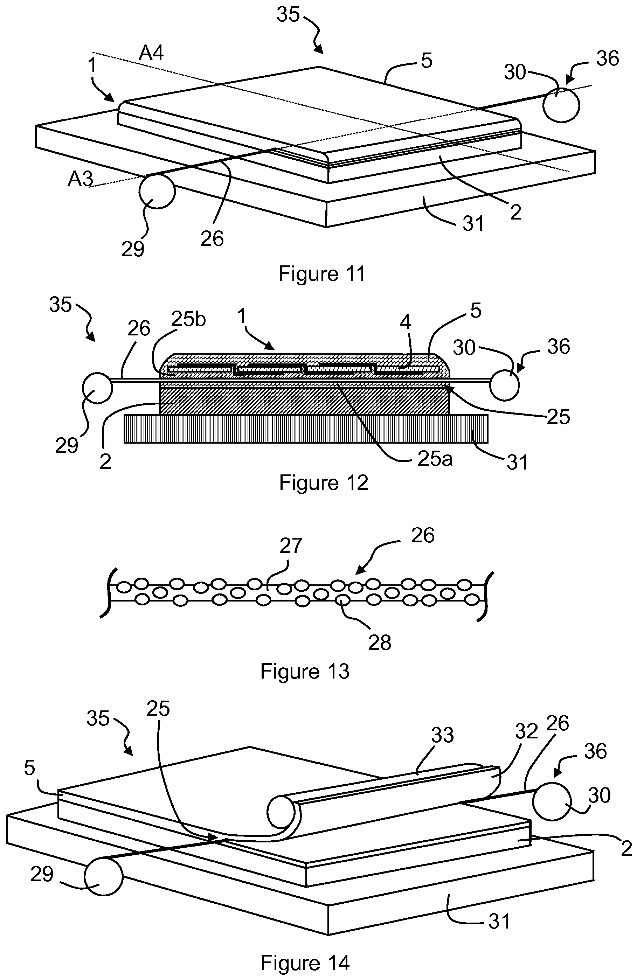

On a décrit ci-avant comment séparer le deuxième élément de protection 3 par rapport aux cellules photovoltaïques 4. Dans le but de recycler au mieux le module photovoltaïque 1, il peut être intéressant de récupérer le premier élément de protection 2 qui peut ensuite être réutilisé pour, par exemple, fabriquer un nouveau module photovoltaïque 1. Autrement dit, il est préféré, via le procédé de désassemblage, de séparer le module photovoltaïque 1 en trois parties : le deuxième élément de protection 3, les cellules photovoltaïques 4 associées à des résidus de l'enveloppe 5, et le premier élément de protection 2. Ces trois parties pourront ensuite être recyclées indépendamment au contraire du broyage de l'art antérieur. La partie comprenant les cellules photovoltaïques 4 associées à des résidus de l'enveloppe 5 entourant les cellules photovoltaïques 4 peut être traitée, par exemple thermiquement, pour récupérer les métaux présents dans les cellules photovoltaïques 4. Pour mettre en œuvre la récupération du premier élément de protection 2, le procédé de désassemblage du module photovoltaïque peut comporter (figures 4, 11 et 12), notamment après l'étape de retrait E2, une étape de séparation E3 des cellules photovoltaïques 4 par rapport au premier élément de protection 2. Cette étape de séparation E3 peut en particulier se faire par découpe d'une portion 25 (aussi visible en figure 2) de l'enveloppe 5, en utilisant un fil abrasif 26. Cette portion 25 est notamment incluse dans le reste de l'enveloppe 5 après retrait du deuxième élément de protection 3. La portion 25 de l'enveloppe 5 correspond à une fraction de l'enveloppe 5 prise selon l'épaisseur de l'enveloppe 5, la portion 25 présentant une épaisseur correspondant à la distance de séparation entre le premier élément de protection 2 et les cellules photovoltaïques 4. Autrement dit, l'étape de séparation E3 peut être mise en œuvre par le passage du fil abrasif 26 dans la portion 25 de l'enveloppe 5 entre le premier élément de protection 2 et les cellules photovoltaïques 4 réalisant ainsi un sciage de la portion 25 de l'enveloppe 5. L'utilisation du fil abrasif 26 présente l'avantage de limiter les coûts liés à la séparation souhaitée, par exemple en ne nécessitant pas l'adjonction d'un système de chauffe du module photovoltaïque 1, en particulier si le fil abrasif 26 est un fil diamanté. Par ailleurs, le risque de casse d'un fil abrasif 26 réalisant une découpe par sciage est moins important que celui d'un fil chauffant, le fil abrasif 26 peut être partiellement renouvelé lors des allers-retours de ce dernier au cours du sciage pour limiter encore plus le risque de casse (par exemple la longueur de fil abrasif déroulé lors de l'aller est alors strictement supérieure à la longueur de fil abrasif enroulé lors du retour). Le fil abrasif 26, peut être tel qu'illustré en figure 13, et peut comporter un fil de support 27, aussi appelé âme centrale, sur lequel sont fixées des particules abrasives 28 représentées schématiquement par des éléments ovales. Le fil de support 27 peut être, par exemple, en acier. Selon une autre formulation, le fil abrasif 26 est formé de particules abrasives 28 maintenues sur l'âme centrale du fil abrasif 26 par un liant. Dans le cadre du fil abrasif, les particules abrasives sont préférentiellement en diamant, autrement dit, le fil abrasif 26 peut être un fil diamanté.

Un fil abrasif, notamment diamanté, est en général utilisé pour découper des matériaux durs comme le saphir, le carbure de silicium (SiC), le nitrure de silicium (Si₃N₄), le silicium (Si). Les matériaux durs sont, par nature, fragiles et cassants. En ce sens, les particules abrasives du fil abrasif pénètrent le matériau à découper de sorte que les particules abrasives du fil abrasif arrachent des copeaux de matière par phénomène d'écaillage ou d'indentation. Par ailleurs, l'utilisation classique du fil abrasif nécessite la présence d'un liquide de coupe au niveau du contact entre le fil abrasif et le matériau à découper. Le liquide de coupe est un liquide de refroidissement et un lubrifiant permettant l'élimination des copeaux et le nettoyage du fil abrasif. Par ailleurs, le liquide de coupe peut aussi être un antioxydant.

Le matériau à découper dans le cadre du module photovoltaïque 1 est un matériau d'encapsulation formant l'enveloppe 5 qui ne présente pas les caractéristiques usuelles des matériaux généralement découpés par fil abrasif, notamment diamanté. Ce matériau peut comporter de l'EVA, ou être à base d'EVA. De manière surprenante le ou les matériaux de l'enveloppe 5, bien que ne présentant pas les caractéristiques usuelles de dureté des matériaux découpés par un fil abrasif (l'EVA présente une dureté strictement inférieure à celle du silicium ou du SiC), peuvent être découpés par le fil abrasif 26 de manière efficace, notamment sans apport extérieur de chaleur. De manière encore plus surprenante, la découpe de la portion 25 de l'enveloppe 5 par le fil abrasif 26 sans utilisation de liquide de coupe procure de meilleurs résultats qu'avec l'utilisation du liquide de coupe. En effet, il a été constaté que l'ajout du liquide de coupe fait augmenter la flèche du (c'est à dire l'amplitude de déformation du) fil abrasif 26 lors de la découpe, ceci pouvant entraîner la casse du fil abrasif 26 du fait de contraintes importantes subies par le fil abrasif 26. Sans liquide de coupe, et dans des conditions similaires de découpe à celles de la découpe avec liquide de coupe, la flèche du fil abrasif 26 reste stable dans le temps, ce qui signifie que le fil abrasif 26 découpe la portion 25 de l'enveloppe 5 de façon régulière. Néanmoins, il est possible d'utiliser un fluide de refroidissement pour réaliser une lubrification intermittente afin de refroidir la portion 25 de l'enveloppe 5 au contact avec le fil abrasif 26. Aux abords de certains matériaux conducteurs de chaleur, tel que des bandes de cuivre formant les connecteurs évoqués précédemment, une légère lubrification permet de limiter la formation d'étincelles. Par légère lubrification on entend une lubrification selon un goutte à goutte de lubrifiant, par exemple une goutte par seconde de lubrifiant, la lubrification pouvant être réalisée par de l'eau, ou de l'eau avec des additifs, pour nettoyer et refroidir le fil 26. Autrement dit, la découpe de la portion 25 de l'enveloppe 5 en utilisant le fil abrasif 26 peut être réalisée à sec (c'est-à-dire sans liquide de coupe).

Le fil abrasif 26, utilisé pour découper la portion 25 de l'enveloppe 5, présente préférentiellement un diamètre strictement inférieur, ou une dimension transversale maximale strictement inférieure, à la distance de séparation entre le premier élément de protection 2 et les cellules photovoltaïques 4. Ceci permet de limiter la découpe par le fil abrasif 26 à l'enveloppe 5. Vu les gammes d'épaisseur présentées ci-avant de l'enveloppe 5 entre le premier élément de protection 2 et les cellules photovoltaïques 4, il est préféré que le diamètre du fil de support 27 portant les particules abrasives 28 du fil abrasif 26 soit compris entre 40µm et 200µm, préférablement compris entre 100µm et 180µm, et idéalement de l'ordre de 150µm. Afin que la découpe utilisant le fil abrasif 26 soit rapide, il est préféré d'avoir des particules abrasives du fil abrasif de taille importante. La taille des particules abrasives utilisées pour former le fil abrasif dépend du diamètre du fil devant les porter. Ainsi, par exemple, la taille des particules abrasives du fil abrasif 26 peut être comprise entre 10µm et 50µm, et préférablement entre 30µm et 40µm pour un fil de support 27 de diamètre égal à 150µm.

Classiquement, le fil abrasif 26 est associé à deux bobines 29, 30 (figures 11, 12) respectivement nommées bobine débitrice 29 et bobine réceptrice 30. Le fil abrasif 26 fait des allers-retours entre ces bobines 29, 30 pour réaliser une découpe par sciage de la portion 25 de l'enveloppe 5. En ce sens, au cours de l'étape de séparation E3, le fil abrasif 26 fait des allers-retours (notamment selon l'axe A3 représenté en figure 11) et il est mis en œuvre un déplacement relatif (selon l'axe A4 représenté en figure 11) entre le fil abrasif 26 et le module photovoltaïque 1 selon une direction sécante, notamment orthogonale à l'allongement du fil abrasif 26, dans une région de découpe de la portion 25.

Le procédé de désassemblage peut comporter une étape de refroidissement E4 (figure 4) du module photovoltaïque 1, et l'étape de séparation E3 est réalisée au cours de l'étape de refroidissement E4 du module photovoltaïque 1. Ce refroidissement permet de rendre plus dure la portion 25 de l'enveloppe 5 pour faciliter sa découpe par le fil abrasif 26. Le refroidissement peut être mis en œuvre par un groupe froid, par effet Peltier, ou par tout autre système permettant d'obtenir le résultat recherché. Par ailleurs, le refroidissement permet aussi d'éviter que des parties découpées ne se recollent après le passage du fil abrasif 26. Notamment, l'étape de refroidissement E4 peut être telle qu'elle assure le maintien de la température du module photovoltaïque entre -100°C et 10°C.

Avantageusement, le procédé de désassemblage comporte une étape de maintien à plat E5 (figure 4) du premier élément de protection 2. L'étape de retrait E2 est mise en œuvre au cours de l'étape de maintien à plat E5 du premier élément de protection 2. Autrement dit, au cours de l'étape de retrait E2, le premier élément de protection 2 est maintenu à plat. Cette étape de maintien à plat E5, notamment illustrée en figures 5 à 10, peut être mise en œuvre par un support 31 sur lequel est placé le module photovoltaïque 1. En particulier, le premier élément de protection 2 est en contact avec le support 31. Le support 31 peut comporter un adhésif, un système d'aspiration sous vide, ou encore un système de maintien mécanique permettant de plaquer le premier élément de protection 2 contre le support 31 pour assurer le maintien à plat. Un avantage du maintien à plat du premier élément de protection 2 est que si le premier élément de protection 2 est voilé, ce dernier sera contraint pour redevenir plat. La mise à plat de du premier élément de protection 2 permet de faciliter l'enlèvement de la partie 9 de l'enveloppe 5. En particulier, grâce au maintien à plat du premier élément de protection 2, le déplacement de la tête de découpe 11 peut se faire sans avoir besoin de guidage assisté par exemple par acquisition d'image : le guidage à partir du plan de structure, ou un déplacement majoritairement rectiligne de la tête de découpe 11, peut suffire. Le maintien à plat permet aussi, le cas échéant, de limiter les modifications de trajectoire de la tête de découpe en cas de guidage. Par ailleurs, le cas échéant, l'étape de séparation E3 est aussi mise en œuvre au cours de l'étape de maintien à plat d'où il résulte que la découpe par le fil abrasif 26 se fait plus facilement uniquement dans le matériau de l'enveloppe 5 car la mise à plat (figures 11, 12) du premier élément de protection 2, notamment sur le support 31, tend aussi à mettre à plat la portion 25 l'enveloppe 5.

De manière applicable à tout ce qui a été décrit précédemment en relation avec l'étape de séparation E3, l'étape de séparation E3 est telle qu'à son terme une première partie 25a (visible en figure 12) de la portion 25 de l'enveloppe 5 reste solidaire du premier élément de protection 2, et une deuxième partie 25b (visible en figure 12) de la portion 25 de l'enveloppe 5 reste solidaire des cellules photovoltaïques 4. La présence de ces première et deuxième parties 25a, 25b de la portion 25 (adoptant par exemple la forme de couches) permet d'assurer que la découpe à l'aide du fil abrasif 26 n'a pas altéré les cellules photovoltaïques 4 ainsi que le premier élément de protection 2 en vue de faciliter par la suite le recyclage, d'une part, du premier élément de protection 2, et, d'autre part, des cellules photovoltaïques 4.

Comme illustré en figure 14, les cellules photovoltaïques peuvent être écartées du premier élément de protection 2 pour éviter un recollage de la partie 25 de l'enveloppe 5 après le passage du fil abrasif 26 faisant des allers-retours entre les bobines 29, 30. Ceci peut être réalisé en mettant en œuvre une étape d'écartement des cellules photovoltaïques par rapport au premier élément de protection 2, par exemple à la manière de ce qui a été décrit en relation avec l'écartement du deuxième élément de protection 3 par rapport aux cellules photovoltaïques. Sur la figure 14, les cellules photovoltaïques, incluses dans une tranche 32 de l'enveloppe 5, sont enroulées autour d'un cylindre 33.

L'invention est aussi relative à une installation pour le désassemblage d'un module photovoltaïque, tel que décrit en relation avec le procédé de désassemblage. Les avantages d'une telle installation découlent de ceux liés au procédé de désassemblage décrit ci-avant. Une telle installation comporte un poste de retrait 34 (figures 5 à 10) du deuxième élément de protection 3 muni d'un outil (par exemple l'organe d'enroulement 16 ou l'outil de traction 17) pour écarter le deuxième élément de protection 3 par rapport aux cellules photovoltaïques 4. Le poste de retrait 34 comporte la tête de découpe 11 configurée de sorte à générer le faisceau 10 de particules énergétiques pour mettre en œuvre un enlèvement de la partie 9 de l'enveloppe 5 lorsque le module photovoltaïque 1 est dans le poste de retrait 34 en vue de désolidariser le deuxième élément de protection 3 par rapport aux cellules photovoltaïques 4. Par ailleurs, l'outil pour écarter le deuxième élément de protection 3 est configuré de sorte à écarter progressivement le deuxième élément de protection 3 par rapport aux cellules photovoltaïques 4 au fur et à mesure de l'avancement de l'enlèvement de la partie 9 de l'enveloppe 5 de sorte que la matière de la partie 9 de l'enveloppe 5 à enlever soit accessible au faisceau 10 de particules énergétiques.

En outre, l'installation peut aussi comporter un poste de découpe 35 (figures 11, 12 et 14) comprenant un outil de découpe 36 muni du fil abrasif 26, et notamment de la bobine débitrice 29 et de la bobine réceptrice 30 évoquées précédemment.

L'installation peut aussi comporter le support 31 évoqué précédemment, le support 31 assurant par exemple le maintien à plat du premier élément de protection 2.

Dans le cadre de l'installation, le support 31 (figures 5 à 12 et 14) permet avantageusement de déplacer le module photovoltaïque 1 du poste de retrait 34 vers le poste de découpe 35. Le support 31 peut donc faire partie d'un système de convoyage du module photovoltaïque 1 appartenant à l'installation.

La tête de découpe peut comporter trois axes de liberté orthogonaux. Pour cela la tête de découpe est dite automatisée. Notamment, la tête de découpe peut être portée par un bras robotisé.

Tout ce qui a été décrit dans le cadre du procédé de désassemblage peut s'appliquer dans le cadre de l'installation de désassemblage et inversement. Notamment, l'installation de désassemblage comporte les moyens matériels, et le cas échéant logiciels, pour la mise en œuvre du procédé de désassemblage.

Le procédé et l'installation de désassemblage décrits ci-avant trouvent une application industrielle dans le cadre du désassemblage d'un ou plusieurs modules photovoltaïques en vue de recycler leurs constituants. En effet, le cas échant, il est alors possible de récupérer le verre dans son intégralité si ce dernier n'est pas cassé, de récupérer le matériau comportant le polymère fluoré (notamment dans son intégralité), de récupérer les éléments actifs du module photovoltaïque comme les cellules photovoltaïques qui pourraient être réutilisées. Ainsi, cela permet notamment de :
- réinjecter des panneaux de verre dans la fabrication de nouveaux modules photovoltaïques,
- de traiter les composés fluorés, si présents dans le deuxième élément de protection 3, dans une filière spécialisée des matériaux toxiques,
- de récupérer les métaux contenus dans les cellules photovoltaïques comme le silicium, l'argent, l'aluminium ou l'indium.

## Revendications

1. Procédé de désassemblage d'un module photovoltaïque (1) comportant :
• un premier élément de protection (2) formant une face avant du module photovoltaïque (1) destinée à être orientée pour recevoir le rayonnement solaire,
• un deuxième élément de protection (3) formant une face arrière du module photovoltaïque (1),
• des cellules photovoltaïques (4) agencées entre le premier élément de protection (2) et le deuxième élément de protection (3),
• une enveloppe (5) d'encapsulation des cellules photovoltaïques (4), ladite enveloppe (5) reliant le premier élément de protection (2) au deuxième élément de protection (3),
ledit procédé de désassemblage comportant une étape de retrait (E2) du deuxième élément de protection (3),
**caractérisé en ce que** l'étape de retrait (E2) du deuxième élément de protection (3) comporte :
• une étape d'enlèvement (E2-1) d'une partie (9) de l'enveloppe (5) en utilisant un faisceau (10) de particules énergétiques issu d'une tête de découpe (11) pour désolidariser le deuxième élément de protection (3) par rapport aux cellules photovoltaïques (4),
• une étape d'écartement (E2-2) progressif du deuxième élément de protection (3) par rapport aux cellules photovoltaïques (4) au fur et à mesure de l'avancement de l'étape d'enlèvement (E2-1) de la partie (9) de l'enveloppe (5), et jusqu'à retrait définitif du deuxième élément de protection,
Et **en ce que** le procédé comporte également :
• une étape de guidage (E2-3) de la tête de découpe (11) pour orienter le faisceau (10) de particules énergétiques au cours de l'étape d'enlèvement (E2-1) de la partie (9) de l'enveloppe (5),
l'étape de guidage (E2-3) comportant :
• une étape de détermination d'une zone du module photovoltaïque (1) dans laquelle le faisceau (10) de particules énergétiques doit être orienté,
• une étape d'utilisation d'un détecteur de matériaux (23) pour déterminer ladite zone,
• une étape de calcul de la trajectoire de la tête de découpe par un module de traitement (24) à partir de données fournies par le détecteur de matériaux (23).

2. Procédé de désassemblage selon la revendication 1, **caractérisé en ce qu'**au cours de l'étape d'enlèvement (E2-1) de la partie (9) de l'enveloppe (5), le faisceau (10) de particules énergétiques se déplace de sorte à mettre en œuvre un enlèvement progressif de matière de la partie (9) de l'enveloppe (5).

3. Procédé de désassemblage selon l'une quelconque des revendications précédentes, **caractérisé en ce que** le faisceau (10) de particules énergétiques est un faisceau laser, ou un jet d'eau abrasif, ou un faisceau laser assisté par un jet d'eau.

4. Procédé de désassemblage selon l'une quelconque des revendications précédentes, **caractérisé en ce que** le faisceau (10) de particules énergétiques se déplace selon une longueur et une largeur du module photovoltaïque (1) de sorte que le faisceau (10) de particules énergétiques provoque un enlèvement de matière de la partie (9) de l'enveloppe (5) sur toute la longueur et sur toute la largeur du module photovoltaïque (1).

5. Procédé de désassemblage selon l'une quelconque des revendications précédentes, **caractérisé en ce que** l'étape d'écartement (E2-2) progressif du deuxième élément de protection (3) par rapport aux cellules photovoltaïques (4) est mise en œuvre par enroulement du deuxième élément de protection (3) autour d'un organe d'enroulement (16), ou par traction du deuxième de protection (3) dans une direction tendant à l'écarter des cellules photovoltaïques (4).

6. Procédé de désassemblage selon l'une quelconque des revendications précédentes, **caractérisé en ce que** l'étape d'écartement progressif (E2-2) du deuxième élément de protection (3) comporte une étape de saisie (E2-2-1) d'un bord du deuxième élément de protection (3) situé à un bord (19) du module photovoltaïque (1), et une étape d'éloignement (E2-2-2) du bord du deuxième élément de protection (3) par rapport audit bord (9) du module photovoltaïque (1).

7. Procédé de désassemblage selon l'une quelconque des revendications précédentes, **caractérisé en ce qu'**à tout moment après le début et avant le terme de l'étape d'enlèvement (E2-1) de la partie (9) de l'enveloppe (5), le deuxième élément de protection (3) comporte :
- une première partie (13) libérée, et
- une deuxième partie (14) reliée au reste du module photovoltaïque (1) par une portion restante (15) de la partie (9) de l'enveloppe (5),
et **en ce que** la première partie (13) libérée est maintenue à l'écart du reste du module photovoltaïque (1) par l'étape d'écartement (E2-2) de sorte que le faisceau (10) de particules énergétiques puisse accéder à ladite portion restante (15).

8. Procédé de désassemblage selon la revendication précédente, **caractérisé en ce que** la tête de découpe (11) suit, au cours de l'étape d'enlèvement (E2-1) de la partie (9) de l'enveloppe (5), une trajectoire établie par l'étape de guidage (E2-3) de la tête de découpe (11).

9. Procédé de désassemblage selon la revendication précédente, **caractérisé en ce que** l'étape de guidage (E2-3) comporte une étape d'acquisition d'images du module photovoltaïque (1), et une étape d'utilisation des images acquises pour établir la trajectoire.

10. Procédé de désassemblage selon l'une quelconque des revendications précédentes, **caractérisé en ce qu'**il comporte, après l'étape de retrait (E2), une étape de séparation (E3) des cellules photovoltaïques (4) par rapport au premier élément de protection (2) par découpe d'une portion (25) de l'enveloppe (5), en utilisant un fil abrasif (26).

11. Procédé de désassemblage selon l'une quelconque des revendications précédentes, **caractérisé en ce qu'**il comporte une étape de maintien à plat (E5) du premier élément de protection (2), l'étape de retrait (E2) étant mise en œuvre au cours de l'étape de maintien à plat du premier élément de protection (2).

12. Installation pour le désassemblage d'un module photovoltaïque (1), ledit module photovoltaïque (1) comportant un premier élément de protection (2) formant une face avant du module photovoltaïque (1) destinée à être orientée pour recevoir le rayonnement solaire, un deuxième élément de protection (3) formant une face arrière du module photovoltaïque (1), des cellules photovoltaïques (4) agencées entre le premier élément de protection (2) et le deuxième élément de protection (3), une enveloppe (5) d'encapsulation des cellules photovoltaïques (4), ladite enveloppe (5) reliant le premier élément de protection (2) au deuxième élément de protection (3), ladite installation comportant un poste de retrait (34) du deuxième élément de protection (3) muni d'un outil pour écarter le deuxième élément de protection (3) par rapport aux cellules photovoltaïques (4), **caractérisée en ce que** :
• le poste de retrait (34) comporte une tête de découpe (11) configurée de sorte à générer un faisceau (10) de particules énergétiques pour mettre en œuvre un enlèvement d'une partie (9) de l'enveloppe (5) lorsque le module photovoltaïque (1) est dans le poste de retrait (34) en vue de désolidariser le deuxième élément de protection (3) par rapport aux cellules photovoltaïques (4), et
• l'outil pour écarter le deuxième élément de protection (3) est configuré de sorte à écarter progressivement le deuxième élément de protection (3) par rapport aux cellules photovoltaïques (4) au fur et à mesure de l'avancement de l'enlèvement de la partie (9) de l'enveloppe (5), et jusqu'à retrait définitif du deuxième élément de protection,
• l'installation comportant :
- des moyens de guidage (E2-3) de la tête de découpe (11) pour orienter le faisceau (10) de particules énergétiques au cours de l'étape d'enlèvement (E2-1) de la partie (9) de l'enveloppe (5),
• Les moyens de guidage comportant :
- des moyens de détermination d'une zone du module photovoltaïque (1) dans laquelle le faisceau (10) de particules énergétiques doit être orienté,
- un détecteur de matériaux (23) pour déterminer ladite zone,
- un module de traitement (24) configuré pour déterminer la trajectoire de la tête de découpe à partir de données fournies par le détecteur de matériaux (23).

## Patentansprüche

1. Verfahren zur Demontage eines Photovoltaikmoduls (1), umfassend:
• ein erstes Schutzelement (2), das eine Vorderseite des Photovoltaikmoduls (1) bildet, die dazu bestimmt ist, zum Aufnehmen der Sonnenstrahlung ausgerichtet zu sein,
• ein zweites Schutzelement (3), das eine Rückseite des Photovoltaikmoduls bildet (1),
• Photovoltaikzellen (4), die zwischen dem ersten Schutzelement (2) und dem zweiten Schutzelement (3) angeordnet sind,
• ein Umhüllung (5) zur Kapselung der Photovoltaikzellen (4), wobei die Umhüllung (5) das erste Schutzelement (2) mit dem zweiten Schutzelement (3) verbindet,
wobei das Verfahren zur Demontage einen Schritt (E2) des Entfernens des zweiten Schutzelements (3) umfasst,
**dadurch gekennzeichnet, dass** der Schritt (E2) des Entfernens des zweiten Schutzelements (3) umfasst:
• ein Schritt (E2-1) des Abtragens eines Teils (9) der Umhüllung (5) unter Verwendung eines Strahls (10) aus energetischen Teilchen, der aus einem Schneidkopf (11) hervorgeht, um das zweite Schutzelement (3) von den Photovoltaikzellen (4) zu lösen;
• ein Schritt (E2-2) des progressiven Beabstandens des zweiten Schutzelements (3) von den Photovoltaikzellen (4) im Zuge des Fortschreitens des Schritts (E2-1) des Abtragens des Teils (9) der Umhüllung (5) bis zur endgültigen Entfernung des zweiten Schutzelements,
und dadurch, dass das Verfahren ferner umfasst:
• einen Schritt (E2-3) des Führens des Schneidkopfes (11), um den Strahl (10) aus energetischen Teilchen während des Schritts (E2-1) des Abtragens des Teils (9) der Umhüllung (5) auszurichten,
wobei der Schritt (E2-3) des Führens umfasst:
• einen Schritt des Bestimmens eines Bereichs des Photovoltaikmoduls (1), auf den der Strahl (10) aus energetischen Teilchen ausgerichtet werden soll;
• einen Schritt des Verwendens eines Materialdetektors (23), um den Bereich zu bestimmen,
• einen Schritt des Berechnens der Bahn des Schneidkopfes durch ein Verarbeitungsmodul (24) ausgehend von vom Materialdetektor (23) bereitgestellten Daten.

2. Verfahren zur Demontage nach Anspruch 1, **dadurch gekennzeichnet, dass** sich der Strahl (10) aus energetischen Teilchen während des Schritts (E2-1) des Abtragens des Teils (9) der Umhüllung (5) so bewegt, dass ein progressives Abtragen von Material des Teils (9) der Umhüllung (5) durchgeführt wird.

3. Verfahren zur Demontage nach einem der vorhergehenden Ansprüche, **dadurch gekennzeichnet, dass** der Strahl (10) aus energetischen Teilchen ein Laserstrahl oder ein abrasiver Wasserstrahl oder ein durch einen Wasserstrahl unterstützter Laserstrahl ist.

4. Verfahren zur Demontage nach einem der vorhergehenden Ansprüche, **dadurch gekennzeichnet, dass** sich der Strahl (10) aus energetischen Teilchen entlang einer Länge und einer Breite des Photovoltaikmoduls (1) bewegt, so dass der Strahl (10) aus energetischen Teilchen ein Abtragen von Material des Teils (9) der Umhüllung (5) über die gesamte Länge und über die gesamte Breite des Photovoltaikmoduls (1) bewirkt.

5. Verfahren zur Demontage nach einem der vorhergehenden Ansprüche, **dadurch gekennzeichnet, dass** der Schritt (E2-2) des progressiven Beabstandens des zweiten Schutzelements (3) von den Photovoltaikzellen (4) durch Aufwickeln des zweiten Schutzelements (3) um ein Wickelorgan (16) oder durch Ziehen des zweiten Schutzelements (3) in eine Richtung, die dazu tendiert, es von den Photovoltaikzellen (4) zu beabstanden, durchgeführt wird.

6. Verfahren zur Demontage nach einem der vorhergehenden Ansprüche, **dadurch gekennzeichnet, dass** der Schritt (E2-2) des progressiven Beabstandens des zweiten Schutzelements (3) einen Schritt (E2-2-1) des Ergreifens einer Kante des zweiten Schutzelements (3), die an einer Kante (19) des Photovoltaikmoduls (1) gelegen ist, und einen Schritt (E2-2-2) des Wegbewegens der Kante des zweiten Schutzelements (3) von der Kante (9) des Photovoltaikmoduls (1) umfasst.

7. Verfahren zur Demontage nach einem der vorhergehenden Ansprüche, **dadurch gekennzeichnet, dass** das zweite Schutzelement (3) jederzeit nach dem Beginn und vor dem Ende des Schritts (E2-1) des Abtragens des Teils (9) der Umhüllung (5) umfasst:
- einen freigelegten ersten Teil (13) und
- einen zweiten Teil (14), der mit dem Rest des Photovoltaikmoduls (1) durch einen verbleibenden Abschnitt (15) des Teils (9) der Umhüllung (5) verbunden ist,
und dass der freigelegte erste Teil (13) vom Rest des Photovoltaikmoduls (1) durch den Schritt (E2-2) des Beabstandens beabstandet gehalten wird, so dass der Strahl (10) aus energetischen Teilchen zu dem restlichen Teil (15) gelangen kann.

8. Verfahren zur Demontage nach dem vorhergehenden Anspruch, **dadurch gekennzeichnet, dass** der Schneidkopf (11) während des Schritts (E2-1) des Abtragens des Teils (9) der Umhüllung (5) einer durch den Schritt (E2-3) des Führens des Schneidkopfes (11) festgelegten Bahn folgt.

9. Verfahren zur Demontage nach dem vorhergehenden Anspruch, **dadurch gekennzeichnet, dass** der Schritt (E2-3) des Führens einen Schritt des Erfassens von Bildern des Photovoltaikmoduls (1) und einen Schritt des Verwendens der erfassten Bilder zum Festlegen der Bahn umfasst.

10. Verfahren zur Demontage nach einem der vorhergehenden Ansprüche, **dadurch gekennzeichnet, dass** es nach dem Schritt (E2) des Entfernens einen Schritt (E3) des Trennens der Photovoltaikzellen (4) von dem ersten Schutzelement (2) durch Abschneiden eines Abschnitts (25) der Umhüllung (5) mit einem Schleifdraht (26) umfasst.

11. Verfahren zur Demontage nach einem der vorhergehenden Ansprüche, **dadurch gekennzeichnet, dass** es einen Schritt (E5) des Flachhaltens des ersten Schutzelements (2) umfasst, wobei der Schritt (E2) des Entfernens während des Schritts des Flachhaltens des ersten Schutzelements (2) durchgeführt wird.

12. Anlage zur Demontage eines Photovoltaikmoduls (1), das Photovoltaik-Modul (1) umfassend ein erstes Schutzelement (2), das eine Vorderseite des Photovoltaikmoduls (1) bildet, die dazu bestimmt ist, zum Aufnehmen der Sonnenstrahlung ausgerichtet zu sein, ein zweites Schutzelement (3), das eine Rückseite des Photovoltaikmoduls (1) bildet, Photovoltaikzellen (4), die zwischen dem ersten Schutzelement (2) und dem zweiten Schutzelement (3) angeordnet sind, eine Umhüllung (5) zur Kapselung der Photovoltaikzellen (4), wobei die Umhüllung (5) das erste Schutzelement (2) mit dem zweiten Schutzelement (3) verbindet; wobei die Anlage eine Station (34) zum Entfernen des zweiten Schutzelements (3) umfasst, die mit einem Werkzeug zum Beabstanden des zweiten Schutzelements (3) von den Photovoltaikzellen (4) versehen ist, **dadurch gekennzeichnet, dass**:
• die Station (34) zum Entfernen einen Schneidkopf (11) umfasst, der so ausgebildet ist, dass er einen Strahl (10) aus energetischen Teilchen erzeugt, um ein Abtragen eines Teils (9) der Umhüllung (5) durchzuführen, wenn sich das Photovoltaikmodul (1) in der Station (34) zum Entfernen befindet, um das zweite Schutzelement (3) von den Photovoltaikzellen (4) zu lösen, und
• das Werkzeug zum Beabstanden des zweiten Schutzelements (3) so ausgebildet ist, dass es das zweite Schutzelement (3) im Zuge des Fortschreitens des Abtragens des Teils (9) der Umhüllung (5) und bis zur endgültigen Entfernung des zweiten Schutzelements progressiv von den Photovoltaikzellen (4) beabstandet,
• wobei die Anlage umfasst:
- Mittel zum Führen (E2-3) des Schneidkopfes (11), um den Strahl (10) aus energetischen Teilchen während des Schritts (E2-1) des Abtragens des Teils (9) der Umhüllung (5) auszurichten,
• wobei die Mittel zum Führen umfassen:
- Mittel zum Bestimmen eines Bereichs des Photovoltaikmoduls (1), auf den der Strahl (10) aus energetischen Teilchen ausgerichtet werden soll,
- einen Materialdetektor (23), um den Bereich zu bestimmen,
- ein Verarbeitungsmodul (24), das dazu ausgebildet ist, die Bahn des Schneidkopfes ausgehend von vom Materialdetektor (23) bereitgestellten Daten zu bestimmen.

## Claims

1. Method for disassembling a photovoltaic module (1), comprising:
• a first protective element (2) forming a front side of the photovoltaic module (1), which side is intended to be oriented to receive solar radiation,
• a second protective element (3) forming a back side of the photovoltaic module (1),
• photovoltaic cells (4) arranged between the first protective element (2) and the second protective element (3),
• a jacket (5) encapsulating the photovoltaic cells (4), said jacket (5) joining the first protective element (2) to the second protective element (3),
said disassembling method comprising a step (E2) of stripping the second protective element (3),
**characterized in that** the step (E2) of stripping the second protective element (3) comprises:
• a step (E2-1) of removing one portion (9) of the jacket (5) using a beam (10) of energetic particles generated by a cutting head (11) so as to detach the second protective element (3) from the photovoltaic cells (4),
• a step (E2-2) of gradually separating the second protective element (3) from the photovoltaic cells (4) as the step (E2-1) of removing the portion (9) of the jacket (5) progresses, until the second protective element is completely stripped,
and **in that** the method also comprises:
• a step (E2-3) of guiding the cutting head (11) so as to orient the beam (10) of energetic particles during the step (E2-1) of removing the portion (9) of the jacket (5),
the guiding step (E2-3) comprising:
• a step of determining a region of the photovoltaic module (1) into which the beam (10) of energetic particles must be oriented,
• a step of using a material detector (23) to determine said region,
• a step of calculating by means of a processing module (24) the path of the cutting head based on data provided by the material detector (23).

2. Disassembling method according to Claim 1, **characterized in that**, during the step (E2-1) of removing the portion (9) of the jacket (5), the beam (10) of energetic particles moves so as to gradually remove material from the portion (9) of the jacket (5).

3. Disassembling method according to any of the preceding claims, **characterized in that** the beam (10) of energetic particles is a laser beam, an abrasive water jet, or a laser beam assisted by a water jet.

4. Disassembling method according to any of the preceding claims, **characterized in that** the beam (10) of energetic particles moves along a length and a width of the photovoltaic module (1) such that the beam (10) of energetic particles causes material to be removed from the portion (9) of the jacket (5) over the entire length and over the entire width of the photovoltaic module (1).

5. Disassembling method according to any of the preceding claims, **characterized in that** the step (E2-2) of gradually separating the second protective element (3) from the photovoltaic cells (4) is carried out by winding the second protective element (3) around a winding mechanism (16), or by pulling the second protective element (3) in a direction tending to separate it from the photovoltaic cells (4).

6. Disassembling method according to any of the preceding claims, **characterized in that** the step (E2-2) of gradually separating the second protective element (3) comprises a step (E2-2-1) of gripping an edge of the second protective element (3) located at an edge (19) of the photovoltaic module (1), and a step (E2-2-2) of moving the edge of the second protective element (3) away from said edge (9) of the photovoltaic module (1).

7. Disassembling method according to any of the preceding claims, **characterized in that** at any time after the start and before the end of the step (E2-1) of removing the portion (9) of the jacket (5), the second protective element (3) comprises:
- a released first portion (13), and
- a second portion (14) joined to the remainder of the photovoltaic module (1) by a remaining segment (15) of the portion (9) of the jacket (5),
and **in that** the released first portion (13) is kept separate from the remainder of the photovoltaic module (1) by the separating step (E2-2) so as to allow the beam (10) of energetic particles to access said remaining segment (15).

8. Disassembling method according to the preceding claim, **characterized in that** the cutting head (11) follows, during the step (E2-1) of removing the portion (9) of the jacket (5), a path established by the step (E2-3) of guiding the cutting head (11).

9. Disassembling method according to the preceding claim, **characterized in that** the guiding step (E2-3) comprises a step of acquiring images of the photovoltaic module (1), and a step of using the acquired images to establish the path.

10. Disassembling method according to any of the preceding claims, **characterized in that** it comprises, after the stripping step (E2), a step (E3) of dissociating the photovoltaic cells (4) from the first protective element (2) by cutting a segment (25) of the jacket (5), using an abrasive wire (26).

11. Disassembling method according to any of the preceding claims, **characterized in that** it comprises a step (E5) of holding the first protective element (2) flat, the stripping step (E2) being carried out during the step of holding the first protective element (2) flat.

12. Apparatus for disassembling a photovoltaic module (1), said photovoltaic module (1) comprising a first protective element (2) forming a front side of the photovoltaic module (1), which side is intended to be oriented to receive solar radiation, a second protective element (3) forming a back side of the photovoltaic module (1), photovoltaic cells (4) arranged between the first protective element (2) and the second protective element (3), a jacket (5) encapsulating the photovoltaic cells (4), said jacket (5) joining the first protective element (2) to the second protective element (3), said apparatus comprising a station (34) for stripping the second protective element (3) equipped with a tool for separating the second protective element (3) from the photovoltaic cells (4), **characterized in that**:
• the stripping station (34) comprises a cutting head (11) configured to generate a beam (10) of energetic particles with a view to removing a portion (9) of the jacket (5) when the photovoltaic module (1) is in the stripping station (34) so as to detach the second protective element (3) from the photovoltaic cells (4), and
• the tool for separating the second protective element (3) is configured to gradually separate the second protective element (3) from the photovoltaic cells (4) as the removal of the portion (9) of the jacket (5) progresses, until the second protective element is completely stripped,
• the apparatus comprising:
- means (E2-3) for guiding the cutting head (11) to orient the beam (10) of energetic particles during the step (E2-1) of removing the portion (9) of the jacket (5),
• the guiding means comprising:
- means for determining a region of the photovoltaic module (1) into which the beam (10) of energetic particles must be oriented,
- a material detector (23) for determining said region,
- a processing module (24) configured to determine the path of the cutting head based on data provided by the material detector (23).
